Europäisches Patentamt

European Patent Office

Office européen des brevets

(19)

(11)     EP 1 168 538 A1

(12)     EUROPEAN PATENT APPLICATION
published in accordance with Art. 158(3) EPC

(43) Date of publication:
    02.01.2002  Bulletin 2002/01

(51) Int Cl.7: **H01S 5/14**

(21) Application number: 01902750.7

(22) Date of filing: 02.02.2001

(86) International application number:
    PCT/JP01/00770

(87) International publication number:
    WO 01/57976 (09.08.2001 Gazette 2001/32)

(84) Designated Contracting States:
    AT BE CH CY DE DK ES FI FR GB GR IE IT LI LU
    MC NL PT SE TR

(30) Priority: 03.02.2000  JP  2000026130
                03.08.2000  JP  2000236284

(71) Applicant: The Furukawa Electric Co., Ltd.
    Tokyo 100-8322 (JP)

(72) Inventors:
    • AIKIYO, Takeshi,
      c/o THE FURUKAWA ELECTRIC CO.LTD
      Chiyoda-ku, Tokyo 100-8322 (JP)

    • YOSHIDA, Junji,
      c/o THE FURUKAWA ELECTRIC CO.LTD.
      Chiyoda-ku, Tokyo 100-8322 (JP)
    • TSUKIJI, Naoki,
      c/o THE FURUKAWA ELECTRIC CO.LTD.
      Chiyoda-ku, Tokyo 100-8322 (JP)
    • KOYANAGI, Satoshi,
      c/o THE FURUKAWA ELECT. CO.LTD.
      Tokyo 100-8322 (JP)

(74) Representative: Modiano, Guido, Dr.-Ing. et al
    Modiano, Josif, Pisanty & Staub, Baaderstrasse
    3
    80469 München (DE)

(54) **SEMICONDUCTOR LASER MODULE AND PUMPING LIGHT SOURCE COMPRISING THE SAME**

(57)    A semiconductor laser module is provided to obtain a high optical output power, prevent kinks in the current - optical output power characteristic, and emit laser light of a narrow spectrum width. Also provided is a pumping light source apparatus which wavelength multiplexes the laser light to obtain a high optical output power. The semiconductor laser module comprises a Fabry-Perot semiconductor laser device with a cavity of 1800µm or more in length and a fiber grating optically coupled to the semiconductor laser device. The reflection bandwidth of the fiber grating is 3nm or less and is greater than the wavelength interval of longitudinal modes of lasing light from the semiconductor device.

FIG. 5

# EP 1 168 538 A1

**Description**

## TECHNICAL FIELD

The present invention relates to semiconductor laser devices and pumping light source apparatuses which employ the device. More particularly, the present invention relates to a Fabry-Perot semiconductor laser device which obtains a high optical output power and is effectively applied to the assembly of a pumping light source apparatus employing wavelength multiplexing for use with an optical fiber amplifier. The present invention also relates to a pumping light source apparatus which employs the laser device to obtain a high optical output power.

## BACKGROUND ART

With the development of DWDM (Dense Wavelength Division Multiplexing) systems, higher optical output gain have been increasingly demanded for,the optical fiber amplifier. This has in turn required strongly higher optical output power as a pumping light source apparatus for use with the optical fiber amplifier.

Recently, research and development is well underway particularly on the Raman amplification by which only an ordinary single-mode optical fiber can be used to obtain optical gain over a significantly wide bandwidth. To obtain high optical gain, the pumping light source apparatus used for the Raman amplification needs to be configured so as to multiplex optical output powers from multiple semiconductor laser modules which oscillate various wavelengths shorter due to the Raman shift than the wavelength range in which a signal light source is amplified by stimulated Raman scattering.

A pumping light source apparatus for obtaining higher output powers is disclosed in U.S. Pat. No. 5,936,763 as follows.

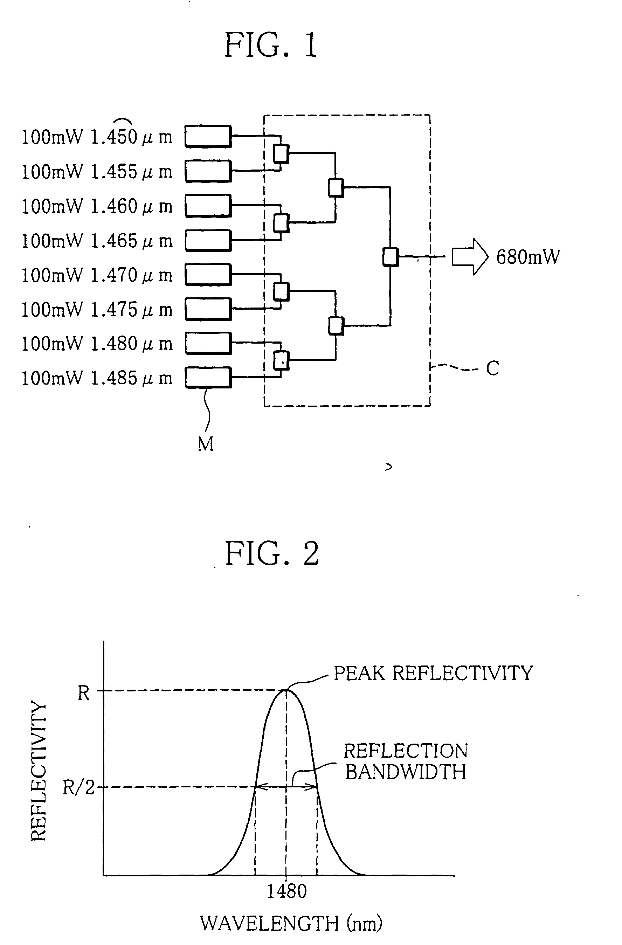

To obtain a high optical output power, this apparatus employs a plurality of semiconductor laser modules oscillated different wavelength each other and a wavelength multiplexing coupler to multiplex the laser beams emitted from the modules. A specific example of such an apparatus disclosed is shown in Fig.1, multiplexing eight semiconductor laser modules M each of which obtains at 100 mW of optical output power and which provide lasing action at intervals of 5nm over the wavelength region from 1450nm to 1485nm. With a wavelength multiplexing coupler C, the apparatus multiplexes the laser beams of lasing wavelengths provided by the laser modules M to obtain an optical output power of 680mW.

When the optical output powers from each module are wavelength multiplexed as in the prior art described above, it is preferable that the wavelength of the lasing light from the Fabry-Perot semiconductor laser device assembled into each module is stabilized at a certain wavelength irrespective of the drive current of the semiconductor laser device and the ambient temperature.

As a method for stabilizing the wavelength of the lasing light emitted from the Fabry-Perot semiconductor laser device assembled into the module, conventionally known is a method for forming a fiber grating in an optical fiber to be optically coupled to the laser device.

Here, the fiber grating means a distribution of refractivity repeatedly changed at predetermined intervals in the longitudinal direction along the core of the optical fiber. As shown in Fig.2, the grating is characterized by showing a reflection spectrum having reflectivity only over the wavelength band about a particular wavelength or a center wavelength (1480nm in the figure). The spectrum width of reflectivity given when the reflectivity has a half of peak reflectivity (R) is called a reflection bandwidth which, like the peak reflectivity, is one of the parameters that characterize the fiber grating.

Suppose that the semiconductor laser device is driven with the fiber grating being optically coupled to the device. In this case, of the lasing light of various wavelengths provided by the semiconductor laser device, only the light of the wavelengths within the reflection wavelength bandwidth about said particular wavelength is fedback to the semiconductor laser device. This allows the wavelength of the lasing light from the semiconductor laser device to be stabilized and optical output power to be obtained within the narrow wavelength region about the particular wavelength.

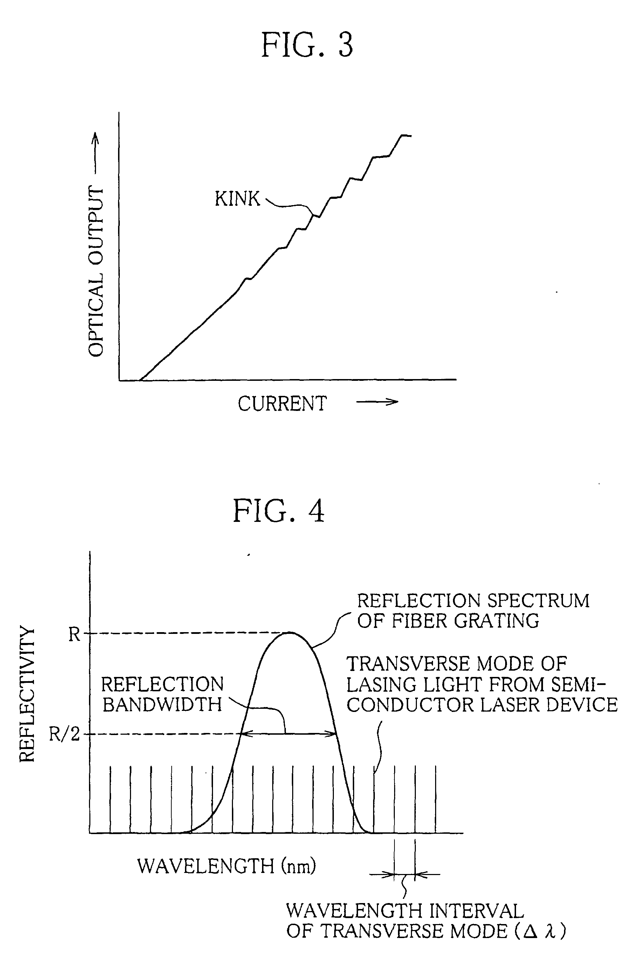

However, a variation in the drive current or ambient temperature of the semiconductor laser device would cause a shift in the longitudinal mode of the lasing light from the semiconductor laser device, thereby resulting in kinks appearing in the current - optical output power characteristic shown in Fig.3.

The semiconductor laser module is controlled for use in a manner such that the pumping laser light to be emitted therefrom is monitored and thus kept constant in intensity. Suppose the aforementioned kinks occur in the lasing light emitted from the semiconductor laser device assembled into the laser module to cause a negative differential coefficient to appear in the current - optical output power characteristic. In this case, there will be raised a problem of making it difficult to perform Automatic Power Control (APC) on the optical output power from the module into which the semiconductor laser device is assembled.

To solve such a problem, the following semiconductor laser module is disclosed in U.S. Pat. No.5,845,030.

2

This module is provided with a fiber grating and configured such that the reflection bandwidth of the fiber grating is set to a value greater than a wavelength interval of the longitudinal mode of the lasing light. Here, the wavelength interval is determined by the cavity length of the semiconductor laser device to be incorporated into the module. More specifically, exemplified is a module incorporating a semiconductor laser device which has a cavity length of 900μm and provides lasing action at a wavelength bandwidth about 1480nm, with the reflection bandwidth of the fiber grating being 2nm or more.

Incidentally, the wavelength interval ($\Delta\lambda$) of the longitudinal mode of the semiconductor laser device is given by the following equation. That is,

$$\Delta\lambda = \lambda^2 / 2n \cdot L \tag{1}$$

where $\lambda$ is the lasing wavelength of the laser light, n is the effective refractive index of the active layer, and L is the length of the cavity.

The Fabry-Perot semiconductor laser device exemplified in the aforementioned U.S. Pat. No.5,845,030 has $\lambda$=1480nm, n=3.5, and L=900μm. Thus, the wavelength interval ($\Delta\lambda$) of the longitudinal mode is found to be approximately 0.35nm from equation (1).

Incidentally, this module is designed to have a reflection bandwidth of the fiber grating, which is greater than the wavelength interval of the longitudinal mode of the lasing light. As shown in Fig.4, this causes some reflection bandwidths (2nm or more) of the fiber grating to include approximately 5.8 longitudinal modes of the semiconductor laser device.

Under this condition, even if the drive current and the ambient temperature of the semiconductor laser device vary and thereby shift the longitudinal modes of the lasing light, causing the longitudinal modes to come into or go out of the reflection bandwidth, since a plurality of longitudinal modes is always present in the reflection bandwidth, the variation has less effect on the optical output characteristic, resulting in reduced kinks in the current - optical output power characteristic.

Incidentally, when the lasing light emitted from the semiconductor laser module with the aforementioned fiber grating is wavelength multiplexed to form a pumping light source apparatus for realizing a high optical output power, it is necessary to narrow the spectrum width of the laser light radiated from the optical fiber of the module to reduce the loss of the wavelength multiplexing coupler of a narrow pass band. This requires the reflection bandwidth of the fiber grating to be made as narrow as possible.

However, as evident from Fig.4, narrowing the reflection bandwidth of the fiber grating would reduce the number of longitudinal modes, which are always included in the reflection bandwidth. This tends to cause kinks to occur in the current - optical output power characteristic, leading to a difficulty in APC control of the optical output power of the module.

As described above, with the conventional pumping light source apparatus, it was difficult to narrow the reflection bandwidth of the fiber grating while optical output power kinks are prevented from occurring in the current - optical output power characteristic of the laser module. Thus, this made it difficult to raise the degree of wavelength multiplexing at the same time while the loss of wavelength multiplexing coupler is being controlled, thereby limiting higher optical output power.

It is an object of the present invention to provide a semiconductor laser module with a fiber grating, which can obtain a high optical output power with kinks being prevented and provide increased degree of wavelength multiplexing.

It is another object of the present invention to realize a pumping light source apparatus for use with an optical fiber amplifier, which wavelength multiplexes the laser light from the aforementioned plurality of laser modules and which can thereby emit pumping laser light of a very high optical output power.

**DISCLOSURE OF THE INVENTION**

To achieve the aforementioned objects, the present invention provides a semiconductor laser module comprising

a Fabry-Perot semiconductor laser device and a fiber grating, optically coupled to each other, wherein
a cavity of said Fabry-Perot semiconductor laser device has a length of 1800μm or more, and
a reflection bandwidth of said fiber grating is 3nm or less, or preferably 2nm or less, and is greater than a wavelength interval of longitudinal modes of lasing light from said Fabry-Perot semiconductor device.

Alternatively, the present invention provides a semiconductor laser module comprising

a Fabry-Perot semiconductor laser device and a fiber grating, optically coupled to each other, wherein

a cavity of said Fabry-Perot semiconductor laser device has a length of 1800μm or more, and

within a reflection bandwidth of said fiber grating, included are two to twenty longitudinal modes of lasing light from said Fabry-Perot semiconductor laser device.

The present invention also provides a Fabry-Perot semiconductor laser device and a semiconductor laser module incorporating the laser device and a fiber grating in combination. The wavelength of the lasing light from said semiconductor laser device is preferably 1000 to 1700nm, or more preferably 1200 to 1550nm. The active layer of said semiconductor laser device is composed of a quantum well structure, and said quantum well structure is a compressive strain quantum well structure having an amount of strain of 0.5% or more. The quantum wells included in said active layer is 10 or less in layer number, said semiconductor laser device has a cavity of 1800 to 3500μm in length, one end surface (front facet) of 2% or less in reflectivity, and the other end surface (rear facet) of 90% or more in reflectivity.

Furthermore, the present invention provides a pumping light source apparatus comprising a plurality of the semiconductor laser modules for oscillating at different wavelengths one another and means for wavelength multiplexing a plurality of laser beams to be emitted from each of the semiconductor laser modules.

## BRIEF DESCRIPTION OF THE DRAWINGS

Fig.1 is a schematic view illustrating a pumping light source apparatus, exemplified in U.S. Pat. No.5,936,763, employing wavelength multiplexing.

Fig.2 is an example of the graphical representation of a reflection spectrum of a fiber grating.

Fig.3 is a graph showing the current - optical output power characteristic of laser light emitted from a laser module.

Fig.4 is an explanatory graph explaining the relationship between the reflection bandwidth of a fiber grating and the longitudinal mode of lasing light of a semiconductor laser device.

Fig.5 is a schematic view showing an example A of a semiconductor laser module according to the present invention.

Fig.6 is a side view showing a semiconductor laser device incorporated into a module A according to the present invention.

Fig.7 is a cross-sectional view taken along the line VII-VII of Fig.6.

Fig.8 is a schematic view showing an example $B_1$ of a pumping light source apparatus according to the present invention.

Fig.9 is a schematic view showing another example $B_2$ of a pumping light source apparatus according to the present invention.

## BEST MODE FOR CARRYING OUT THE INVENTION

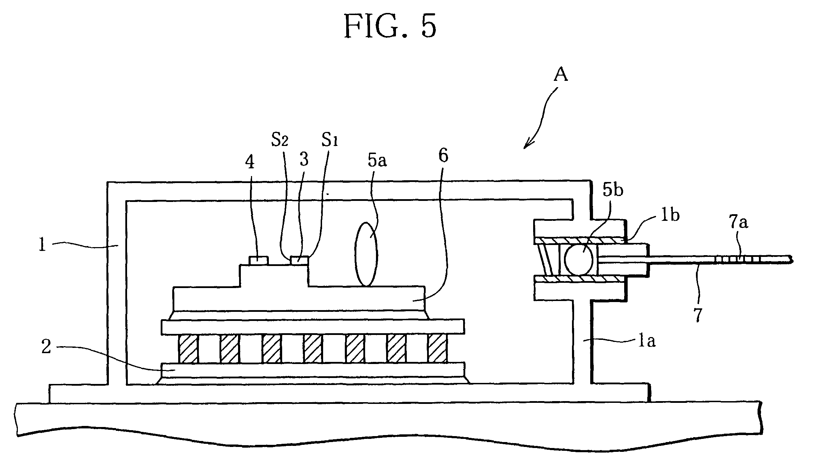

Fig.5 shows an example of a module A according to the present invention.

Referring to Fig.5, there is arranged a Peltier module 2 in a package 1. On the Peltier module 2, there is fixedly arranged a substrate 6 onto which fixed are a semiconductor laser device 3, described later, a thermistor 4, and a lens 5a. Moreover, in a through-hole 1b provided in a sidewall 1a of the package 1, there are fixed an optical fiber 7 having a fiber grating 7a, described later, and a lens 5b.

In the module A of Fig.5, the lasing light emitted from the front facet $S_1$ of the semiconductor laser device 3 is condensed through the lenses 5a, 5b to be incident upon the edge surface of the optical fiber 7, propagating through the core of the optical fiber. Then, of the propagating laser beams, those of specific wavelengths are reflected on the fiber grating 7a to be fedback to the semiconductor laser device.

At this time, in the step of driving the laser device 3, the increased drive current causes the optical output power the lasing light emitted from the laser device 3 higher, and the laser device 3 to generated heat and thus rise in temperature, thereby resulting in a variation in wavelength. Accordingly, the thermistor 4 arranged near the laser device 3 is adapted to measure the temperature of the device. The resulting measurements are used to activate an external control circuit (not shown) to adjust the operating current of the Peltier module 2, thereby controlling the laser device 3 so as to be kept at a constant temperature.

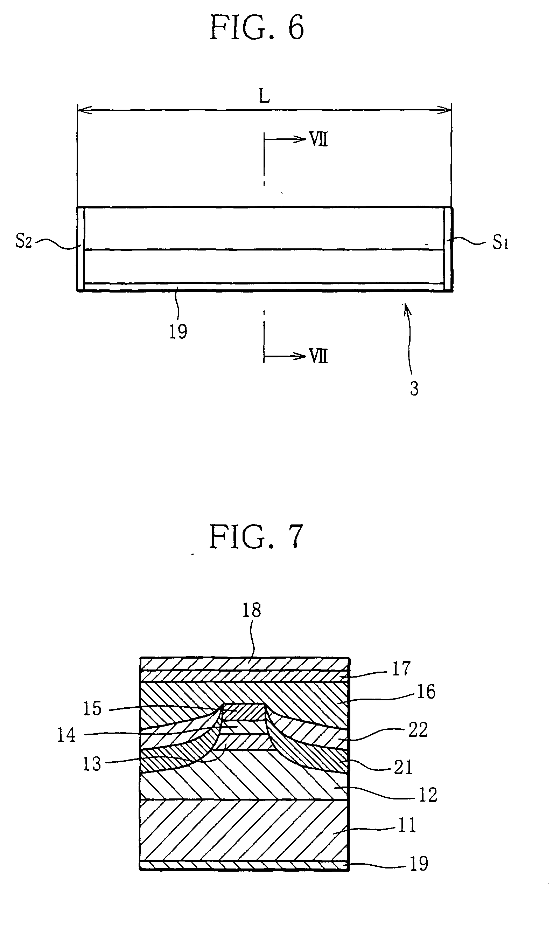

The semiconductor laser device incorporated into the module A is of a Fabry-Perot type, an example of which is shown in Fig.6 and Fig.7 which is a cross-sectional view taken along line VII-VII of Fig.6.

The laser device 3 is fabricated, for example, by a known epitaxial growth method such as the metal organic vapor phase epitaxial growth method, the liquid phase epitaxial growth method, the molecular beam epitaxial growth method, the gas source molecular beam epitaxial growth method, or the chemical beam epitaxial growth method. That is, predetermined semiconductors are epitaxially grown on a substrate 11 of a predetermined semiconductor to form a grown layer structure, described later. Thereafter, the structure is cleaved to form a cavity of a predetermined length (L). Moreover, a low reflective film, described later, is formed on one of the cleaved facets to form a front facet $S_1$, while a high reflective film is formed on the other cleaved facet to form a rear facet $S_3$. Furthermore, the laser device 3 has a lower electrode 19 formed on the reverse surface of the substrate 11 and an upper electrode 18 formed on the upper surface of the stacked layer structure.

The stacked layer structure shown in Fig.7 has a buried hereto (BH) structure. For example, on the substrate 11 of n-InP, stacked successively are a lower cladding layer 12 of n-InP, a lower GRIN-SCH layer 13 of non-doped GaInAsP, an active layer 14 of GaInAsP composed of in a lattice mismatched multiple quantum well structure, and an upper GRIN-SCH layer 15 of non-doped GaInAsP. On the upper GRIN-SCH layer 15, for example, further stacked are an upper cladding layer 16 of p-InP and a cap layer 17 of p-GaInAsP. In addition, the upper electrode 18 is formed on top of the cap layer 17, while the lower electrode 19 is formed on the reverse surface of the substrate 11.

In addition, for example, a p-InP layer 21 and an n-InP layer 22 are stacked in that order on the side surfaces of the aforementioned lower cladding layer 12, the lower GRIN-SCH layer 13. the active layer 14, and the upper GRIN-SCH layer 15. This allows a confinement portion to be formed for injecting current into the active layer 14.

This stacked layer structure has the active layer 14 comprising of a lattice mismatched multiple quantum well structure. More specifically, the active layer 14 is comprising of a compressive strain multiple quantum well structure with the lattice mismatch ratio of the well layer 14 to the substrate 11 being 0.5% or more.

Incidentally, this embodiment employs a strained quantum well structure, but the present invention can also be implemented with a lattice matched quantum well structure. However, the strained quantum well structure is preferably employed to reduce the internal absorption of the laser cavity, thereby allowing the laser device to obtain a higher output power. Moreover, it is preferable to make the lattice mismatch amount of 0.5% or more to obtain this effect.

In addition, the strained quantum well structure can have the barrier layer formed in a strain compensating structure which introduces tensile strain opposite to the strain of the well layer in order to satisfy the lattice matching condition in an equivalent manner. Thus, it is not particularly necessary to set an upper limit to the lattice mismatch amount of the well layer.

However, when no strain compensating structure is employed, the crystalline state would be degraded due to the strain energy accumulated in the active layer. In particular, the larger the number of wells and the thicker the well layer, the greater the strain energy becomes. Thus, the degradation in crystalline would become more significant, interfering with a higher optical output power operation and highly reliable operation of the laser device.

Therefore, when no strain compensating structure is employed, the lattice mismatch amount of the compression strained quantum well layer is made 2% or less, or more preferably 1.5% or less, from the viewpoint of the operation characteristics and long-term reliability of the laser device.

In addition, according to the present invention, the number of wells can be appropriately selected so as not to greatly change the volume of the active layer and is substantially made equal to 10 or less. This is because an excessively high volume of the active layer would cause the internal loss unique to the material of the active layer to have greater effect on and thus interfere with a higher output power operation.

The semiconductor laser device according to the present invention has the cavity of length (L) as long as 1800μm or more, which is described later. This causes the effect of the internal loss of the laser device to have a comparatively greater effect than that of a laser device with a shorter cavity. However, when the well layer is made 17nm or less in thickness and the number of wells is made five or less, the effect of said internal loss can be more positively neglected. Thus, the number of wells is preferably 10 or less and more preferably 1 to 5.

In the laser device 3, the cavity length (L) is set to 1800μm or more.

In general, the longer the cavity length (L) is made, the less the series resistance of the device and the larger the heat radiating area become. This makes it possible to prevent the saturation of the optical output power due to the generation of heat in the device, that is, the thermal saturation is prevented in the device. This, in turn, makes it possible to increase the drive current, thereby allowing the optical output power of the laser device to increase.

In addition, when the cavity length (L) is made longer, the wavelength interval ($\Delta\lambda$) of the longitudinal modes becomes narrower which is given by equation (1). Thus, it is made possible to obtain an increased optical output power with the pumping laser light that is obtained by combining the wavelength multiplexed beams of light emitted from a pumping light source apparatus assembled for wavelength multiplexing.

Thus, the wavelength interval ($\Delta\lambda$) of the longitudinal mode of the lasing light emitted from the laser device 3 is narrowed. Therefore, even when the reflection bandwidth of the fiber grating formed on the optical fiber, described later, is narrowed, a plurality of longitudinal modes can always be included in the reflection bandwidth. This causes the spectrum width of the pumping laser light launched from the optical fiber to be narrowed and thus kinks can be prevented in the current - optical output power characteristic even with a fiber grating of a narrow reflection bandwidth.

On the other hand, making the cavity length (L) of the semiconductor laser device simply longer would cause the mirror loss to decrease and internal loss of the cavity to have a greater effect. This will in turn cause the external differential quantum efficiency to decrease and the optical output power obtained by the semiconductor laser device to be thereby reduced. In this context, even when the fiber grating is coupled with the device to form a module, it is difficult for the module to obtain a high optical output power.

In view of the aforementioned circumstances, the semiconductor laser module with a fiber grating according to the present invention is configured as follows to solve the aforementioned problems. That is, the conventional laser device has a low reflective film with its reflectivity being generally constant (for example, about 4%) irrespective of the cavity length (L). On the other hand, the laser device 3 is provided with a low reflective film of reflectivity less than the conventional value over the range of the cavity length (L) 1800μm or more. Furthermore, the reflectivity is made lower with increasing cavity length (L).

That is, the semiconductor laser device 3 to be used for the semiconductor laser module with the fiber grating according to the present invention is configured to have a cavity of length (L) 1800μm or more, the front facet $S_1$ of reflectivity 2% or less, and the rear facet $S_3$ of reflectivity 90% or more. With such a configuration as with a cavity of length (L) 1800μm or more, it is possible to obtain an optical output power of 500mW or more from the front facet $S_1$ of the semiconductor laser device 3. This results in an optical output power about 1.7 times higher than that of about 300mW obtained by a semiconductor laser device with a cavity of length (L) about 1000μm.

Furthermore, as the cavity is made longer in length, the heat radiating area becomes larger, thereby making it possible to implement a laser device of considerably low power consumption.

However, an excessive cavity length (L) would cause the aforementioned disadvantageous problem of exerting an effect on the high optical output power operation. Furthermore, during the cleaving step in the manufacturing process of the semiconductor laser device 3, this would cause a crack or break to occur in the midway of the cavity and thus reduce the manufacturing yield of the device. In addition, laser devices to be obtained from one wafer will decrease in number as the cavity length (L) is made longer. Considering these situations, it is preferable in the present invention to set the upper limit of the cavity length (L) to 3500μm.

Accordingly, the laser device 3 assembled into a semiconductor laser module with a fiber grating makes it possible to allow the module to obtain a high optical output power. In addition, even with a fiber grating of a narrow reflection bandwidth, kinks are prevented in the current - optical output power characteristic, thereby making it possible to provide a narrow spectrum width of the lasing light to be emitted. That is, even when the module is coupled to a wavelength multiplexing coupler of a narrow pass band, the loss of the coupler is reduced to provide an increased degree of wavelength multiplexing, thus making it possible to assemble a pumping light source apparatus of a high optical output power.

Now, with the module A shown in Fig.5, the lasing light from the front facet $S_1$ of the semiconductor laser device 3 is condensed at lenses 5 to be incident upon the edge surface of the optical fiber 7 and then propagates through the core of the optical fiber. Then, of the propagating beams of laser light, those of specific wavelengths are reflected on the fiber grating 7a to be fedback to the laser device.

For example, the module A according to the present invention has the aforementioned fiber grating 7a of peak reflectivity 2 to 10%. The reflection bandwidth is 3nm or less, preferably 2nm or less, more preferably 1.5nm or less, or still more preferably 1nm or less. Moreover, the reflection bandwidth is set to a value greater than the wavelength interval (Δλ) of the longitudinal mode of the lasing light emitted from the aforementioned laser device 3.

In particular, when the module A is employed for use with a Raman amplifier, it is necessary to allow most part (for example, 90%) of the optical output power to be included in the region of the pumping laser light of spectrum width 2nm under all of the used temperature condition and driving condition. To satisfy this necessary condition, it is preferable to make the reflection bandwidth of the fiber grating 2nm or less.

For example, suppose that laser devices of cavity length (L) 1800μm, 2500μm, 3200μm, and 3500μm are coupled with fiber gratings of reflection bandwidth 1nm, 1.5nm, 2nm, and 3nm, respectively. In this case, shown in Table 1 are the wavelength interval (Δλ) of the longitudinal mode of the lasing light from the laser device and the number of longitudinal modes exist within the reflection bandwidth of the fiber grating.

Incidentally, the numerical values shown in Table 1 are obtained with λ=1480nm and n=3.5 in the aforementioned equation (1).

Table 1

| Cavity length (L: μm) | Wavelength interval of longitudinal mode (Δλ:nm) | The number of longitudinal modes exist within reflection bandwidth | | | |
|---|---|---|---|---|---|
| | | For reflection bandwidth of 1.0nm | For reflection bandwidth of 1.5nm | For reflection bandwidth of 2.0nm | For reflection bandwidth of 3.0nm |
| 1800 | 0.17 | 5.8 | 8.6 | 11.6 | 17.3 |
| 2500 | 0.13 | 8.0 | 12.0 | 16.0 | 24.0 |
| 3200 | 0.098 | 10.2 | 15.3 | 20.5 | 30.7 |
| 3500 | 0.089 | 11.2 | 16.8 | 22.4 | 33.6 |

For example, in the case where the laser device of cavity length (L) 1800μm is coupled with the fiber grating of reflection bandwidth 3nm or less, it is possible to include the maximum number of 17.3 longitudinal modes within the reflection bandwidth of the fiber grating.

Accordingly, even when the drive current or the ambient temperature of the laser device 3 varies, this module can prevent kinks in the current - optical output power characteristic since a plurality of longitudinal modes are always exist in the aforementioned reflection bandwidth.

On the other hand, even in a case where the reflection bandwidth of the fiber grating is made 2nm, 1.5nm, and further as narrow as 1nm to narrow the spectrum width of the lasing light from the optical fiber, at least about 5.8 longitudinal modes will be included within the reflection bandwidth of the fiber grating as in the aforementioned U.S. Pat. No.5,845,030, thereby preventing kinks in the current - optical output power characteristic.

Furthermore, with a cavity of length (L) 1800μm or more, it is made possible to further increase the number of longitudinal modes included in the reflection bandwidth of the fiber grating as shown in Table 1. This makes it possible to prevent kinks in the current - optical output power characteristic more positively.

Incidentally, in each example described above referring to Table 1, the following conditions should be naturally satisfied to prevent kinks in the current - optical output power characteristic. That is, the reflection bandwidth of the fiber grating should be greater than the longitudinal mode interval of the laser device, or two or more longitudinal modes should be exist within the reflection bandwidth of the fiber grating.

As described above, the present invention allows the reflection bandwidth to be appropriately designed in accordance with the cavity length (L) of the laser device 3 to be incorporated into the module A. This makes it possible to include a plurality of longitudinal modes within the reflection bandwidth of the fiber grating, thereby preventing kinks in the current - optical output power characteristic.

Conversely, it is possible to design the cavity length (L) appropriately to provide a narrow reflection bandwidth of the fiber grating, allowing a plurality of longitudinal modes to be present therein.

Incidentally, as the number of longitudinal modes exist within the reflection bandwidth increases, kinks are prevented more effectively in the current - optical output power characteristic. However, it is preferable to design the cavity length (L) and the value of the reflection bandwidth so as to make the aforementioned longitudinal number equal to 2 to 20.

For example, for the semiconductor laser device of cavity length (L) 1800μm, the wavelength interval (Δλ) of the longitudinal modes is 0.17nm. Therefore, when the reflection bandwidth of the fiber grating 7a is formed to be 1.0nm, about 5.8 longitudinal modes will be included within the reflection bandwidth as in the aforementioned U.S. Pat. No.5,845,030, thereby preventing kinks in the current - optical output power characteristic.

On the other hand, in the case where the cavity length (L) is made 3200μm, the long cavity length (L) will allow the optical output power of lasing light from the front facet $S_1$ of the semiconductor laser device 3 to be made higher, with the wavelength interval (Δλ) of the longitudinal modes being made 0.098nm at the same time. Therefore, for example, when the reflection bandwidth of the fiber grating 7a is made 1nm, about 10 longitudinal modes will be exit within the reflection bandwidth. This allows laser light of a higher optical output power to be launched from the optical fiber 7 and prevents kinks in the current - optical output power characteristic.

Furthermore, when the fiber grating 7a is provided with a narrower reflection bandwidth, the spectrum width of the laser light launched from the optical fiber 7 becomes narrower. For example, as described above, for a reflection bandwidth of 1nm, the spectrum width of the laser light (of wavelength 1480nm) launched from the optical fiber 7 is as narrow as about 1nm. Therefore, when the laser light is wavelength multiplexed with a wavelength multiplexing coupler, the loss is reduced and it is thereby made possible to increase the degree of the wavelength multiplexing. That is, with this module, it is made possible to assemble a pumping light source apparatus for performing wavelength multiplexing to obtain a high optical output power.

Incidentally, the aforementioned spectrum width means the wavelength width at which the intensity is reduced by 10dB from the peak intensity in the spectrum curve of the laser light.

Now, a pumping light source apparatus according to the present invention will be explained below.

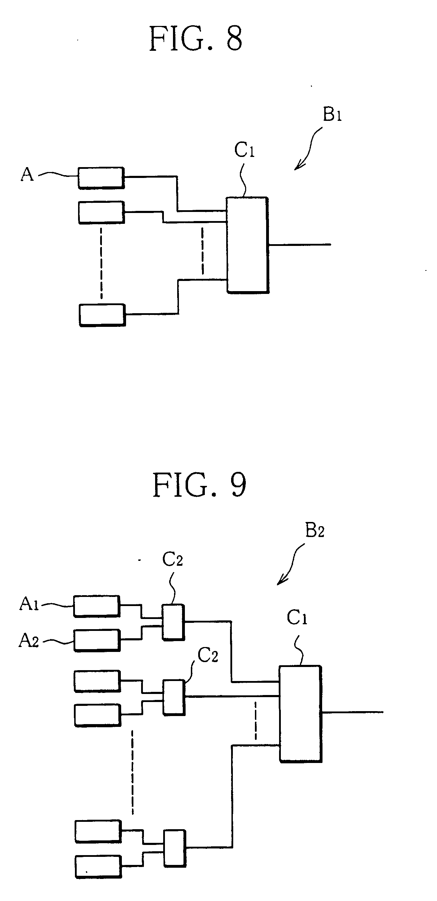

Fig. 8 is a schematic diagram showing an example $B_1$ of a pumping light source apparatus according to the present invention.

The apparatus $B_1$ comprises a plurality of the aforementioned semiconductor laser modules A according to the present invention and means (a wavelength multiplexing coupler) $C_1$ for wavelength multiplexing the wavelengths of the laser light launched from those modules.

Here, the modules A are designed to have fiber gratings incorporated therein with their center wavelengths different from each other at 2.5nm intervals, each module launching laser beams of different wavelengths. In addition, the laser device of each module has a cavity of length (L) 1800µm or more, with the reflection bandwidth of the fiber grating 3nm or less, preferably 3nm or less, more preferably 1.5nm or less, or still more preferably 1nm or less. The laser device is also designed to include a sufficient number of longitudinal modes in the reflection bandwidth to prevent kinks in the current - optical output power characteristic.

Therefore, with this apparatus $B_1$, the optical fiber of each module A launches laser light of a narrower spectrum width, thereby reducing the loss in the wavelength multiplexing means $C_1$.

With this apparatus $B_1$, this makes it possible to increase the number of the modules A which can be coupled to the wavelength multiplexing means $C_1$, allowing the apparatus $B_1$ to serve as a pumping light source apparatus that obtains an extremely high optical output power.

Fig.9 is a schematic view showing another example of a pumping light source apparatus $B_2$ according to the present invention.

The apparatus $B_2$ comprises two modules $A_1$, $A_2$ which provide lasing action at the same wavelength and launch laser beams having directions of polarization orthogonal to each other. The apparatus $B_2$ also comprises a polarization beam combiner (PBC) $C_2$ for combining laser beams launched from the modules and the aforementioned wavelength multiplexing means $C_1$ for wavelength multiplexing a plurality of laser beams prepared by shifting the wavelength of the multiplexed laser beams.

Like the apparatus $B_1$, the apparatus $B_2$ also serves as a pumping light source apparatus for providing an extremely high optical output power.

Incidentally, the wavelength multiplexing pumping light source apparatus, which is exemplified in the aforementioned U.S. Pat. No. 5,936,763, employs modules into which incorporated are DFB laser devices which lase at 1480nm, have a cavity of length 900µm, and obtain an optical output power of 100mW.

On the other hand, the module according to the present invention can be manufactured at lower cost than the aforementioned DFB laser device, and is provided with a Fabry-Perot semiconductor laser device which has a cavity of length (L) 1800µm and obtains optical output power of about 500mW.

Accordingly, in a case where the coupling efficiency between the laser device and the optical fiber is about 85% and the insertion loss caused by the fiber grating is about 8%, an optical output power of about 390mW can be obtained from the optical fiber of the module according to the present invention.

As described above, the present invention provides a module and a pumping light source apparatus which can be fabricated at far lower cost and obtain an extremely higher optical output power than the aforementioned prior-art module and the pumping light source apparatus employing the prior-art module.

Conversely, to obtain a predetermined optical output power, the pumping light source apparatus according to the present invention can employ a less number of modules and wavelength multiplexing means, to be incorporated therein, than the number of the prior-art ones. This makes it possible to reduce the apparatus in cost and size.

**APPLICABILITY TO INDUSTRY**

As evident from the foregoing explanations, the semiconductor laser module according to the present invention incorporates a semiconductor laser device of a cavity of length (L) 1800µm or more and a fiber grating of reflection bandwidth 3nm or less. This makes it possible to output laser light of a narrow spectrum width, while allowing a plurality of longitudinal modes to present in the reflection bandwidth.

For this reason, the module can output laser light whose kinks are prevented in the current - optical output power characteristic and which is preferable for simultaneous wavelength multiplexing.

Furthermore, the pumping light source apparatus according to the present invention incorporates the aforementioned module, thus providing an extremely high optical output power and being useful as a pumping light source apparatus for use with an optical fiber amplifier.

**Claims**

1. A semiconductor laser module comprising

   a Fabry-Perot semiconductor laser device and a fiber grating, optically coupled to each other,
   a cavity of said Fabry-Perot semiconductor laser device having a length of 1800μm or more, and
   a reflection bandwidth of said fiber grating being 3nm or less and being greater than a wavelength interval of longitudinal modes of lasing light from said Fabry-Perot semiconductor device.

2. The semiconductor laser module according to claim 1, wherein the reflection bandwidth of said fiber grating is 2nm or less.

3. A semiconductor laser module comprising

   a Fabry-Perot semiconductor laser device and a fiber grating, optically coupled to each other,
   a cavity of said Fabry-Perot semiconductor laser device having a length of 1800μm or more, and
   two to twenty longitudinal modes of lasing light from said Fabry-Perot semiconductor laser device being included within a reflection bandwidth of said fiber grating.

4. The semiconductor laser module according to any one of claims 1 to 3, wherein the wavelength of the lasing light from said Fabry-Perot semiconductor laser device is 1200 to 1550nm.

5. The semiconductor laser module according to any one of claims 1 to 3, wherein an active layer of said Fabry-Perot semiconductor laser device is composed of a quantum well structure, and said quantum well structure is a compressive strain quantum well structure having an amount of strain of 0.5% or more.

6. The semiconductor laser module according to claim 5, wherein the quantum wells included in said active layer is 10 or less in number.

7. The semiconductor laser module according to any one of claims 1 to 6, wherein said Fabry-Perot semiconductor laser device has a cavity of 1800 to 3500μm in length, a front facet of 2% or less in reflectivity, and a rear facet of 90% or more in reflectivity.

8. A pumping light source apparatus comprising

   a plurality of semiconductor laser modules, according to any one of claims 1 to 7, for launching laser beams at wavelengths different from one another, and means for wavelength multiplexing a plurality of laser beams to be launched from each of the semiconductor laser modules.

# FIG. 1

100mW 1.450 μm

100mW 1.455 μm

100mW 1.460 μm

100mW 1.465 μm

100mW 1.470 μm

100mW 1.475 μm

100mW 1.480 μm

100mW 1.485 μm

M

680mW

C

# FIG. 2

PEAK REFLECTIVITY

R

R/2

REFLECTION BANDWIDTH

REFLECTIVITY

1480

WAVELENGTH (nm)

# FIG. 3

KINK

OPTICAL OUTPUT →

CURRENT →

# FIG. 4

REFLECTION SPECTRUM OF FIBER GRATING

TRANSVERSE MODE OF LASING LIGHT FROM SEMI-CONDUCTOR LASER DEVICE

REFLECTION BANDWIDTH

REFLECTIVITY

R

R/2

WAVELENGTH (nm)

WAVELENGTH INTERVAL OF TRANSVERSE MODE ($\Delta \lambda$)

EP 1 168 538 A1

# FIG. 5

A

S2  S1

4  3  5a  6  5b  1b  7a

1

2

1a

7

# FIG. 6

# FIG. 7

# FIG. 8

# FIG. 9

## INTERNATIONAL SEARCH REPORT

International application No.

PCT/JP01/00770

A. CLASSIFICATION OF SUBJECT MATTER
Int.Cl$^7$   H01S 5/14

According to International Patent Classification (IPC) or to both national classification and IPC

B. FIELDS SEARCHED

Minimum documentation searched (classification system followed by classification symbols)
Int.Cl$^7$   H01S 5/00 - 5/50

Documentation searched other than minimum documentation to the extent that such documents are included in the fields searched
Jitsuyo Shinan Koho        1922-1996    Toroku Jitsuyo Shinan Koho   1994-2001
Kokai Jitsuyo Shinan Koho  1971-2001    Jitsuyo Shinan Toroku Koho   1996-2001

Electronic data base consulted during the international search (name of data base and, where practicable, search terms used)
JICST FILE(JOIS)

C. DOCUMENTS CONSIDERED TO BE RELEVANT

| Category* | Citation of document, with indication, where appropriate, of the relevant passages | Relevant to claim No. |
|---|---|---|
| A | JP, 10-62654, A (The Furukawa Electric Co., Ltd.), 06 March, 1998 (06.03.98), Full text; all drawings   (Family: none) | 1-8 |
| A | EP, 812040, A2 (SUMITOMO ELECTRIC INDUSTRIES, LTD.) 31 October, 1997 (31.10.97) Full text; all drawings & JP, 9-283847, A   & US, 5845030, A | 1-8 |
| A | JP, 8-201609, A (Fujikura Ltd.), 09 August, 1996 (09.08.96), Full text; all drawings   (Family: none) | 1-8 |
| A | Atsushi Hamakawa et al., "WAVELENGTH STABILIZATION OF 1.48μm PUMP LASER BY FIBER GRATING", 22nd European Conference on Optical Communication - ECOC'96, Oslo, 1996, Vol.1, pp.119-122 | 1-8 |
| A | JP, 5-315705, A (NEC Corporation), 26 November, 1993 (26.11.93), Full text; all drawings   (Family: none) | 1-8 |

☒   Further documents are listed in the continuation of Box C.        ☐   See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

Date of the actual completion of the international search
26 April, 2001 (26.04.01)

Date of mailing of the international search report
15 May, 2001 (15.05.01)

Name and mailing address of the ISA/
Japanese Patent Office

Authorized officer

Facsimile No.

Telephone No.

Form PCT/ISA/210 (second sheet) (July 1992)

15

**EP 1 168 538 A1**

### INTERNATIONAL SEARCH REPORT

International application No.

PCT/JP01/00770

C (Continuation).   DOCUMENTS CONSIDERED TO BE RELEVANT

| Category* | Citation of document, with indication, where appropriate, of the relevant passages | Relevant to claim No. |
|---|---|---|
| A | Akihiko KASUGAWA, et al., "Hikari Fiber Amplifier you Koushutsuryoku Handoutai Laser", Technical Research Report, the Institute of Electronics, Information and Communication Engineers, Vol.96, No.188, pp.23-30 | 1-8 |
| A | Joachim Peprek et al., "Cavity Length Effects on Internal Loss and Quantum Efficiency of Multiquantum Well Lasers" IEEE Journal of Selected Topics in quantum Electronics, 1999, Vol.5, No.3, pp.643-647 | 1-8 |
| A | Kelvin Prosyk et al., "Well Number, Length, and Temperature Dependence of Efficiency and Loss in InGaAsP-InP Compressively Strained MQW Ridge Waveguide Lasers at 1.3μm" IEEE Journal of Quantum Electronics 1997, Vol.33, No.8, pp.1360-1368 | 1-8 |

Form PCT/ISA/210 (continuation of second sheet) (July 1992)

16